# FASCICULE DE BREVET EUROPEEN

(11) **EP 3 186 546 B1**
(45) Date de publication et mention de la délivrance du brevet: **05.04.2023**
(21) Numéro de dépôt: 15753914.9
(22) Date de dépôt: 04.08.2015
(51) Int. Cl.: F21S 41/148, F21S 45/47, F21S 45/49

(54) **SYSTEME D'ECLAIRAGE ET/OU DE SIGNALISATION AVEC ORGANE DE REFROIDISSEMENT**
BELEUCHTUNGS- UND/ODER SIGNALSYSTEM MIT KÜHLKÖRPER
LIGHTING AND/OR SIGNALLING SYSTEM WITH COOLING MEMBER

(30) Priorité: 29.08.2014 FR 1458137
(43) Date de publication de la demande: 05.07.2017
(73) Titulaire: Valeo Vision, 93012 Bobigny Cedex (FR)
(72) Inventeur: DUARTE, Marc, F-93250 Villemomble (FR); STEFURA, Eric, F-94100 Saint-Maur-des-Fossés (FR); JACQUEMIN, Paul, F-75010 Paris (FR); CLETO, Christophe, F-75017 Paris (FR); REDJEM SAAD, Lotfi, F-75003 Paris (FR); ELHACHIR, Brahim, F-75019 Paris (FR)
(74) Mandataire: Valeo Visibility
(86) Numéro de dépôt international: PCT/EP2015/067992
(87) Numéro de publication internationale: WO 2016/030156

(56) Documents cités:
- CN-A- 103 185 328
- CN-U- 202 056 819
- CN-U- 203 273 812
- DE-A1-102009 007 612
- JP-A- 2008 059 965
- JP-A- 2010 146 817
- US-A1- 2007 053 168
- US-A1- 2010 002 453
- US-A1- 2011 278 633
- US-A1- 2014 153 248
- US-B1- 7 492 599

## Description

### DOMAINE TECHNIQUE DE L'INVENTION

L'invention concerne le domaine des systèmes d'éclairage et/ou de signalisation pour véhicule automobile. Elle concerne plus particulièrement, un organe de refroidissement pour un tel système.

Elle trouve pour application particulièrement avantageuse mais non limitative le domaine des projecteurs pour véhicules.

### ÉTAT DE LA TECHNIQUE

Les projecteurs automobiles sont habituellement composés d'un boîtier qui est fermé par une paroi transparente à travers laquelle émergent un ou plusieurs faisceaux lumineux. Ce boîtier loge au moins un module optique, comprenant principalement une source lumineuse et un système optique apte à modifier au moins un paramètre de la lumière générée par la source lumineuse pour l'émission du faisceau lumineux par le module optique.

L'évolution des techniques tend à favoriser l'utilisation de sources lumineuses constituées d'au moins une DEL (Diode Electroluminescente), en raison de leur faible consommation en énergie, de leur faible encombrement et de la qualité de l'éclairage obtenu.

Cependant les DEL présentent comme inconvénient qu'en utilisation elles produisent de la chaleur qui est nuisible à leur fonctionnement. En effet, plus une DEL monte en température, plus son flux lumineux diminue.

Lorsque le module optique est conçu pour générer un faisceau nécessitant une forte intensité lumineuse, tel que pour des feux de croisement, des feux de route ou des feux anti-brouillard. Le nombre de DEL et/ou la puissance nécessaire à leur fonctionnement est élevé. A titre indicatif, une telle puissance de fonctionnement élevée est susceptible d'être comprise entre 5 W et 60 W.

Pour assurer un refroidissement efficace à l'intérieur du boîtier au-dessus d'une puissance de fonctionnement de 10 Watts (10 W), il est connu du document WO2005116520 d'induire un passage forcé d'un flux d'air le long des ailettes, suivant l'orientation de la direction générale d'émergence de la lumière hors du module optique. L'exploitation d'un tel flux d'air en passage forcé présente l'inconvénient d'avoir à mettre en oeuvre des moyens spécifiques pour provoquer le flux d'air et d'augmenter l'encombrement à l'intérieur du projecteur. Le coût et la complexité du projecteur sont également élevés.

Il a aussi été proposé d'agencer un dissipateur de chaleur sous forme d'ailettes ou d'une plaque moulée au contact de la DEL. Les documents FR2840151 ou FR2853200 présentent ce type de plaque. Ces solutions présentent pour inconvénient de présenter une efficacité limitée pour évacuer les calories.

Le document JP2008059965 A présente un projecteur de véhicule automobile comprenant un organe de refroidissement avec une base et des ailettes obtenues par un procédé de pliage d'un feuillard.

Ainsi, en dépit des solutions existantes, il existe toujours un besoin consistant à proposer une solution pour refroidir de manière plus efficace un système d'éclairage et/ou de signalisation tout en conservant un encombrement et une complexité limités.

### RÉSUMÉ DE L'INVENTION

Pour atteindre cet objectif, un aspect de la présente invention concerne un système d'éclairage et/ou de signalisation pour véhicule comprenant un organe de refroidissement, l'organe comprenant une base présentant deux faces planes opposées dont l'une au moins est configurée pour supporter une source lumineuse dudit système et au moins un dispositif dissipateur de chaleur en liaison de conduction thermique à ladite base, le dispositif dissipateur comprenant une pluralité d'éléments dissipateurs. L'élément dissipateur comprend au moins une paroi dissipatrice s'étendant depuis une face de fixation prise parmi l'une desdites faces de la base et dans un plan incliné par rapport au plan de la face de fixation, la paroi dissipatrice ou au moins certaines des parois dissipatrices de l'élément dissipateur se prolongeant respectivement par une portion de fixation par laquelle l'élément dissipateur est rapporté et fixé sur ladite face de fixation, la portion de fixation étant formée venu de matière avec la paroi dissipatrice correspondante.

L'invention permet ainsi de former séparément la base et le dispositif dissipateur. La base peut alors être fabriquée par un procédé typiquement de moulage par injection, de matriçage, d'emboutissage, voire d'usinage. Cela permet de faciliter l'obtention d'une masse importante pour favoriser l'extraction des calories de la DEL et leur absorption au sein de la base. Le dispositif dissipateur peut quant à lui être réalisé par un procédé, typiquement de découpage et de pliage d'une feuille métallique, facilitant l'obtention d'un profil présentant un rapport élevé de surface d'échange avec l'air sur masse. Cela permet de favoriser la dissipation thermique dans l'air par convection.

Les matériaux et procédés de fabrication pour la base et le dispositif dissipateur peuvent donc être choisis librement et indépendamment.

On peut ainsi choisir des matières présentant une moins bonne qualité d'échange thermique mais significativement moins coûteuses.

Par ailleurs, les portions de fixation permettent d'améliorer le transfert des calories depuis la base vers le dispositif dissipateur, sans pour autant nuire à la libre circulation de l'air le long des parois dissipatrices.

Par ailleurs, les parois dissipatrices s'étendant depuis la face de fixation ou depuis la face opposée à cette dernière, ce qui accroît l'évacuation des calories depuis la base vers les parois dissipatrices.

Par ailleurs, l'invention offre la possibilité de disposer les ailettes en porte-à-faux tout en conservant une bonne surface de contact pour la conduction et la résistance. Le porte à faux permet la circulation de l'air le long des ailettes.

La connexion de la LED, par wire bonding (câblage de connexion) implique que la LED est directement en contact avec la base, par exemple collée. Par conséquence, la propagation de l'énergie thermique de la source vers les dissipateurs est plus courte et donc plus efficace.

Selon l'invention :
- la portion de fixation est formée venu de matière avec la paroi dissipatrice et s'étend principalement dans le plan de ladite face de fixation ; cela permet d'augmenter la surface de contact entre cette paroi dissipatrice et la base, favorisant ainsi le transfert thermique vers la paroi dissipatrice.
- la portion de fixation et la paroi dissipatrice correspondante sont formées par une tôle pliée, un pli de cette tôle séparant la portion de fixation et la paroi dissipatrice correspondante. Selon un mode de réalisation la portion de fixation et la paroi dissipatrice sont à un angle de 90° au niveau du pli.

De manière facultative, l'invention peut en outre présenter au moins l'une quelconque des caractéristiques optionnelles suivantes prises séparément ou en combinaison :
- l'élément dissipateur présente une discontinuité de matière entre la portion de fixation d'une première paroi dissipatrice et une deuxième paroi dissipatrice adjacente à la première paroi dissipatrice.
- chaque paroi dissipatrice de chaque élément dissipateur se prolonge par une portion de fixation par laquelle l'élément dissipateur est rapporté et fixé sur la base, la portion de fixation étant formée venu de matière avec la paroi dissipatrice.
- La portion de fixation s'étend perpendiculairement à ladite paroi dissipatrice qu'elle prolonge de manière à former une ailette.
- L'élément dissipateur est fixé à la base uniquement par la portion de fixation.
- Les parois dissipatrices forment des ailettes.
- L'élément dissipateur est rapporté sur la base.
- La paroi dissipatrice s'étend principalement dans un plan défini par une direction perpendiculaire au plan de la face de la base depuis laquelle s'étend la paroi dissipatrice et une direction parallèle au plan de ladite face.
- L'organe comprend au moins une portion de fixation distincte par paroi dissipatrice.
- La paroi dissipatrice s'étend notamment selon une direction d'extension principale qui est parallèle au plan de la face de fixation. Une portion proximale de la paroi dissipatrice est disposée au droit de la face de fixation et une portion distale de la paroi dissipatrice est disposée en porte-à-faux par rapport à la face de fixation. La portion distale disposée en porte à faux, prise selon ladite direction d'extension principale présente une longueur d'au moins 0.5 et de préférence d'au moins 0.75 la longueur totale de la paroi dissipatrice prise selon cette même direction d'extension principale.

Ainsi, l'élément dissipateur est en grande partie éloigné de la base ce qui favorise la dissipation dans l'air de la chaleur transmise depuis la base à l'élément dissipateur.
- Chaque élément dissipateur est formé par pliage. Typiquement il est formé à partir d'une tôle ou d'un feuillard plié.
- Le pliage d'un élément dissipateur forme un canal de circulation d'air délimité par deux parois dissipatrices.
- Le canal est ouvert à deux de ses extrémités selon une direction perpendiculaire à la face de la base sur laquelle est rapporté le dispositif dissipateur.
- Dans un mode de réalisation il est ouvert selon la direction d'extension principale de la paroi dissipatrice. Dans un autre mode de réalisation il est fermé selon la direction d'extension principale. Il forme alors par exemple des alvéoles. Le dissipateur forme une structure alvéolaire, chaque canal formant une alvéole.
- Les éléments dissipateurs sont liés les uns aux autres.
- Les éléments dissipateurs sont ensemble formés venu de matière, deux parois dissipatrices adjacentes présentant une continuité de matière.
- Le dispositif dissipateur est formé par pliage d'une même pièce. De préférence, la pièce est pliée en continu selon un ensemble de canaux adjacents de convection de l'air. Le pliage forme par exemple en accordéon.
- Chaque élément dissipateur est formé par pliage à partir d'une pièce distincte, les éléments dissipateurs étant individuellement rapportés sur la base.
- chaque élément dissipateur est constitué par une tôle pliée distincte, les éléments dissipateurs étant distincts de la base et fixés sur cette dernière, notamment par de la colle ou par une soudure.

Ils peuvent être rapportés successivement ou préférentiellement en bloc sur la base.
- L'association d'éléments dissipateurs individuels, de préférence deux éléments individuels, forme un canal.
- Selon un mode de réalisation, la portion de fixation de la première paroi dissipatrice est rapportée au contact de l'un parmi : la deuxième paroi dissipatrice adjacente à la première paroi dissipatrice ou une portion de fixation de la deuxième paroi dissipatrice.

- Alternativement, la portion de fixation de la première paroi dissipatrice est rapportée à une distance inférieure à la distance D de l'un parmi : la deuxième paroi dissipatrice adjacente à la première paroi dissipatrice ou la portion de fixation de la deuxième paroi, la distance D étant inférieure ou égale à la moitié de la distance séparant les première et deuxième parois dissipatrices au niveau des portions de fixation. De préférence, la distance D étant inférieure ou égale au quart de la distance séparant les première et deuxième parois dissipatrices au niveau des portions de fixation. La distance D est mesurée selon une direction parallèle au plan de la face de fixation et selon une direction perpendiculaire à une direction principale selon laquelle s'étendent les parois dissipatrices. La distance D est mesurée au niveau des extrémités proximales de deux parois dissipatrices consécutives.
- l'épaisseur des parois dissipatrices de l'élément dissipateur est comprise entre 0,4 et 1 millimètre; l'épaisseur de la base est comprise entre 2 et 6 millimètre; la distance entre deux parois dissipatrices adjacentes est comprise entre 4 et 12 millimètres.
- La base est prise parmi l'un des matériaux suivants ou un alliage à base de l'un des matériaux suivants : Aluminium 1050 ou 1060 ;
- Les éléments dissipateurs sont pris parmi l'un des matériaux suivants ou un alliage à base de l'un des matériaux suivants : aluminium 1050 ou 1060 ;
- Le dispositif dissipateur comprend au moins un élément de liaison rapporté sur au moins pluralité et de préférence toutes les parois dissipatrices et liant entre elles les parois dissipatrices de ladite pluralité.
- L'élément de liaison forme une barre fixée par soudage ou brasage sur les parois dissipatrices de ladite pluralité.
- L'élément de liaison forme un peigne emboité sur les parois dissipatrices de ladite pluralité.
- la base est un matériau moulé ou extrudé. Selon un mode de réalisation préféré, la base est moulée et les ailettes sont constituées de plaques embouties. Les plaques embouties peuvent être un alliage Alu à 90%, ce qui permet d'avoir une conduction thermique améliorée.
- Le dispositif dissipateur comprend au moins un crochet solidaire d'une portion de fixation et configuré pour coopérer avec une ouverture pratiquée dans une portion de fixation adjacente.
- une portion de fixation porte une partie mâle configurée pour coopérer par emboitement avec une partie femelle portée par une portion de fixation adjacente, la coopération les parties mâles et femelle empêchant le désemboitement des portions de fixation adjacentes selon certains mouvements relatifs des portions de fixation adjacentes.
- Selon un mode de réalisation les canaux sont formés par des ailettes jointes deux à deux de manière à former un « U ». Selon un mode de réalisation, les extrémités des branches du « U » reposant en partie sur la base.

Selon l'invention, le système d'éclairage et/ou de signalisation comprend en outre un dispositif optique configuré pour modifier la direction du rayonnement lumineux émis par la source.

Selon l'invention, le système comprend une source lumineuse supportée par la face de fixation de ladite base.

Selon un mode de réalisation, le dispositif optique du système d'éclairage et/ou de signalisation comprend des composants optiques qui sont par exemple constitués d'un réflecteur, d'une lentille, d'un élément diffusant ou d'un collimateur, voire tout autre organe apte à modifier au moins l'un des paramètres de la lumière générée par la source lumineuse, tel que sa réflexion moyenne et/ou sa direction.

Un procédé, non revendiqué, de réalisation d'un organe de refroidissement selon la revendication 1 comprend notamment les étapes suivantes :
- réaliser la base ;
- réaliser le dispositif dissipateur en effectuant au moins les étapes suivantes :
   ∘ découper une tôle pour former au moins une partie destinée à former une paroi dissipatrice d'un élément dissipateur et au moins une partie destinée à former une portion de fixation prolongeant ladite paroi;
   ∘ plier de la tôle pour que la portion de fixation soit disposée dans un plan incliné par rapport au plan de ladite paroi dissipatrice ;
- reporter l'élément dissipateur en fixant la portion de fixation sur une face de la base.

De manière facultative, l'invention, et notamment le procédé précédemment décrit, peut en outre présenter au moins l'une quelconque des caractéristiques optionnelles suivantes prises séparément ou en combinaison.
- la base est obtenue par moulage, moulage par injection, extrusion, emboutissage ou usinage.
- la fixation de la portion de fixation sur une face de la base est réalisée par une interface thermique, par exemple de la colle:
- selon un mode de réalisation, une pluralité au moins d'éléments dissipateurs, et de préférence tous les éléments dissipateurs, présentent entre eux une continuité de matière et sont formés à partir d'une même tôle.
- la dite pluralité d'éléments dissipateurs est rapporté en bloc sur la base.
- De préférence chaque élément dissipateur comprend deux parois dissipatrices parallèles. De préférence chaque élément dissipateur comprend deux parois dissipatrices parallèles. Selon un mode de réalisation chaque élément dissipateur comprend deux parois dissipatrices parallèles repliées l'une parallèlement à l'autre de manière à former un canal ouvert.
- selon un autre mode de réalisation une pluralité au moins d'éléments dissipateurs, et de préférence tous les éléments dissipateurs, sont formés individuellement avant d'être rapportés sur la face de la base.
- De préférence, les éléments dissipateurs sont rapportés en bloc sur la face de la base.
- De préférence chaque élément dissipateur comprend deux parois dissipatrices parallèles.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- La Figure 1 représente un exemple de réalisation de l'invention, dans lequel l'organe de refroidissement est associé à une carte comprenant un circuit imprimé (PCB).
- La Figure 2 représente un autre exemple de réalisation dans lequel l'organe de refroidissement comporte deux éléments dissipateurs associés à une même base.
- Les Figures 3a à 3e illustrent plusieurs variantes du principe illustré en figures 1 et 2.
- La Figure 4a illustre de façon détaillée un exemple de dispositif dissipateur.
- Les Figures 4b à 4h illustrent plusieurs étapes conduisant à l'obtention du dispositif dissipateur de la figure 4a.
- Les Figures 5a à 5c illustrent un mode de réalisation dans lequel le dispositif dissipateur forme des canaux alvéolaires.
- Les Figures 6a et 6b illustrent en détail un élément dissipateur du dispositif dissipateur illustré en figures 5a à 5c.
- Les figures 7 0 10b illustrent plusieurs solutions permettant de renforcer la fixation des éléments dissipateurs formant ensemble le dispositif dissipateur.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier les dimensions relatives des différents éléments ne sont pas forcément représentatives de la réalité.

### DESCRIPTION DÉTAILLÉE DE L'INVENTION

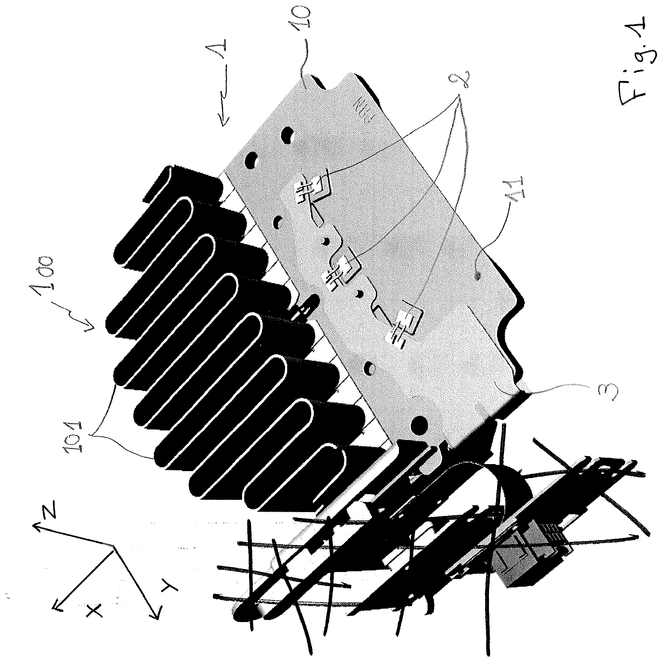

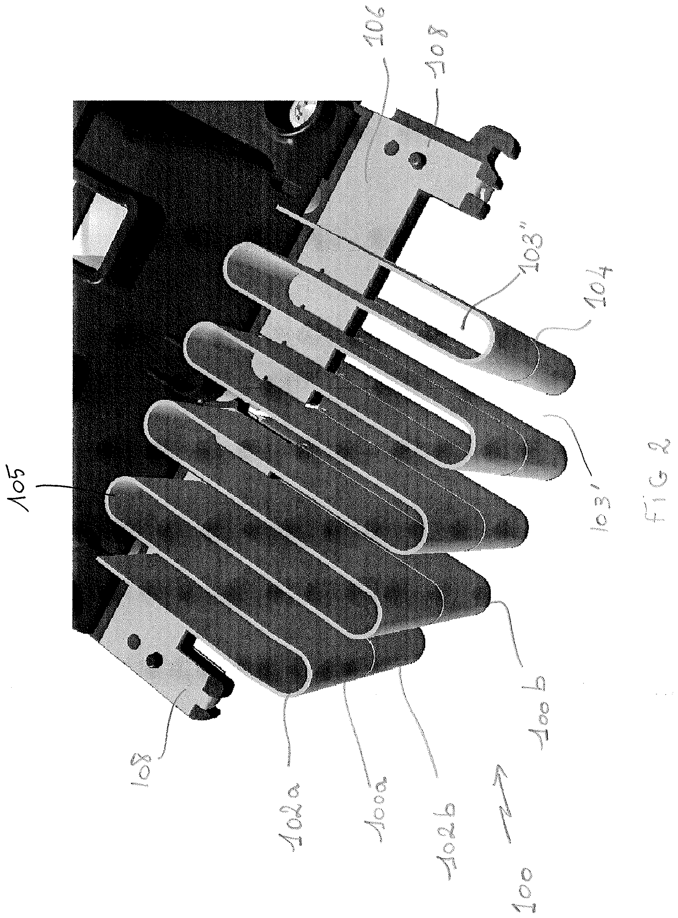

Un premier mode de réalisation de l'invention va maintenant être décrit en référence aux **figures 1** **et** **2****.**

Le système d'éclairage et/ou de signalisation comporte une ou plusieurs sources lumineuses 2. De préférence, il s'agit de DEL. Elles sont au nombre de trois sur cet exemple non limitatif de réalisation.

Les DEL 2 sont électriquement connectées à un circuit électronique, par exemple sous forme d'un circuit imprimé formant une PCB (carte à circuit imprimé) rigide ou flexible. Les DEL 2 sont supportées par une base 10. De manière préférée mais non limitative, les DEL 2 sont directement au contact de la base 10.

La base 10 forme ainsi un support pour les DEL 2. La base 10 fait également partie d'un organe de refroidissement 1 pour le système d'éclairage et/ou de signalisation.

A cet effet, la base 10 est en liaison de conduction thermique avec la DEL 2. Elle absorbe la chaleur produite par la DEL 2 afin de refroidir cette dernière.

L'organe de refroidissement 1 comporte également un dispositif dissipateur 100 de chaleur.

Le dispositif dissipateur 100 est en liaison de conduction thermique avec la base 10. Il présente également une pluralité de parois dissipatrices 102 disposées au contact de l'air et dont la fonction est de dissiper par convection les calories transmises depuis la base 10 au dispositif dissipateur 100.

Ainsi, la chaleur générée par la DEL 2 est extraite de cette dernière et transmise par la base 10 par conduction. Une partie au moins de la chaleur absorbée par la base 10 est ensuite transmise, principalement par conduction, au dispositif dissipateur 100 qui la dissipe ensuite par convection dans le milieu environnant, typiquement de l'air.

La base 10 comprend au moins une portion qui présente deux faces opposées et sensiblement planes. Cette portion de base peut ainsi être qualifiée de semelle dans l'exemple illustré. Selon d'autres modes de réalisation, la base 10 présente des portions additionnelles à la semelle.

Ces deux faces sont contenues dans des plans parallèles illustrés en figure 1. L'une des faces sensiblement plane est configurée pour accueillir et supporter la DEL 2.

De manière avantageuse, au moins l'une de ces deux faces est configurée pour coopérer avec le dispositif dissipateur 100 afin d'assurer la fixation de ce dernier à la base 10. Cette face est par la suite désignée face de fixation 11. Sur l'exemple illustré en figure 1, la face supérieure, celle supportant les DEL 2, fait office de face de fixation 11 pour le dispositif dissipateur 100 illustré.

Le dispositif dissipateur 100 présente une pluralité d'éléments dissipateurs 101 portant chacun deux parois dissipatrices 102. Ces éléments dissipateurs 101 sont de préférence disposés de manière parallèle les uns aux autres. Les parois dissipatrices 102 s'étendent depuis la base 10 et dans un plan incliné par rapport au plan xy des faces de la base 10 et notamment de la face de fixation 11. Comme illustré, elles peuvent s'étendre selon un plan perpendiculaire à celui des faces de la base 10, c'est-à-dire selon le plan zx.

De manière particulièrement avantageuse, les éléments dissipateurs 101 s'étendent selon la direction x en présentant un porte-à-faux par rapport à la base 10. Ces éléments dissipateurs 101 sont fixés à la base 10 sur une portion de leur dimension selon l'axe x qui n'excède pas 0,5 et de préférence qui n'excède pas 20% de la dimension totale de l'élément dissipateur 101 selon cette direction x. Cela permet d'augmenter la surface d'échange entre l'élément dissipateur 101 et l'air environnant de manière à optimiser la dissipation de chaleur par convection.

De manière particulièrement avantageuse, les éléments dissipateurs 101 présentent des portions de fixation 107 configurées pour assurer une double fonctionnalité :
- la fixation de l'élément dissipateur 101 à la base 10 ;
- le transfert par conduction des calories depuis la base 10 vers l'élément dissipateur 101.

Ces portions de fixation 107 sont adjacentes aux parois dissipatrices 102. Alors que les parois dissipatrices 102 sont contenues dans un plan différent de celui de la face de fixation 11 (plan xy), de préférence perpendiculaire (plan zx), les portions de fixation 107 sont contenues dans un plan parallèle (xy) à celui de la face de fixation 11. Cela permet de prévoir une surface de contact importante entre la base 10 et la portions de fixation 107 pour augmenter la tenue des éléments dissipateurs 101 et augmenter le transfert des calories depuis la base 10 vers le dispositif dissipateur 100.

De manière particulièrement avantageuse, chaque portion de fixation 107 prolonge l'une des parois dissipatrices 102. Elles forment une même et unique pièce, de préférence formée venu de matière.

Avantageusement, la paroi dissipatrice 102 et la portion de fixation 107 sont obtenues à partie d'une même tôle ou d'un même feuillard et sont pliées pour être disposées dans deux plans différents.

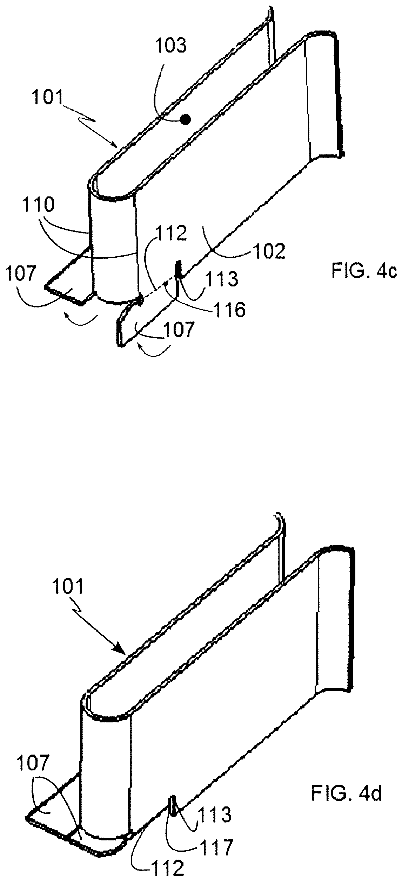

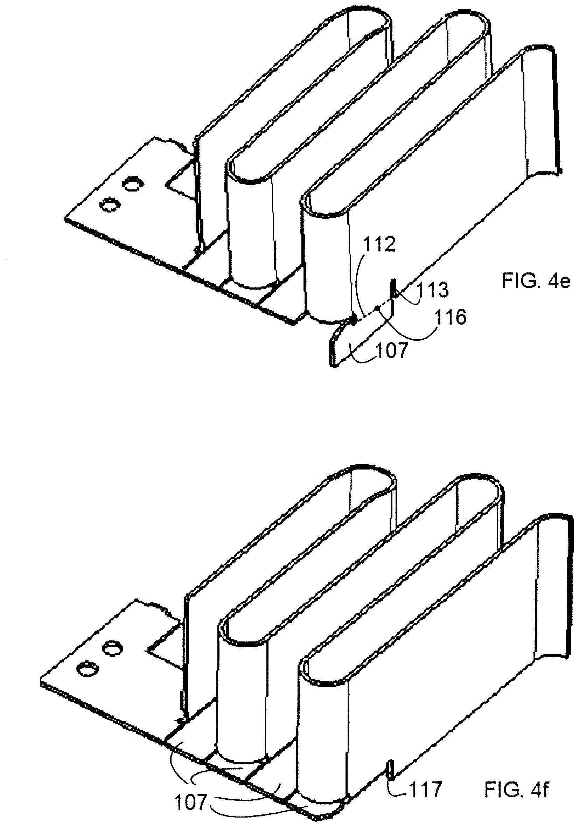

Elles présentent alors une jonction 116, illustrée en figures 4c et 4e par exemple. Cette jonction 116 et cette continuité de matière améliorent le transfert des calories entre la portion de fixation 107 au contact de la base 10 et les parois dissipatrices 102.

Ainsi et de manière particulièrement avantageuse, le dispositif dissipateur 100 est rapporté sur la base 1 et peut donc être réalisé de manière indépendante de la base 10. L'invention offre ainsi une grande liberté de choix tant dans les matériaux que dans les procédés de fabrication pour chacun de la base 10 et de l'élément dissipateur 101.

Par exemple, on réalisera la base 10 par moulage ou par moulage par injection (« die casting » en anglais) ou encore par estampage ou matriçage (« stamping » en anglais). Cela permet d'obtenir de manière simple et peu chère une base 10 présentant une grande densité thermique afin d'offrir une grande capacité à extraire la chaleur hors de la DEL 2 et à l'emmagasiner au sein de la base 10. Si la base 10 est formée par moulage, on choisit par exemple un alliage à base d'aluminium, par exemple un alliage d'aluminium et de silicium, avec une teneur massique d'environ 11%. Cela permet de faciliter le bon remplissage du moule. Si la base 10 est formée par estampage, on pourra alors utiliser de l'aluminium ou un alliage d'aluminium présentant une proportion plus élevée d'aluminium (typiquement supérieure à 90%). Cela permet d'améliorer la conductivité thermique de la base 10.

En ce qui concerne le dispositif dissipateur 100, on le réalisera de préférence par pliage à partir d'une tôle ou d'un feuillard préalablement découpé. Cette technique permet, contrairement au moulage ou à l'estampage, d'obtenir aisément des épaisseurs fines. Typiquement, l'épaisseur de la tôle pliée correspond à l'épaisseur des parois dissipatrices 102. Les éléments dissipateurs 101 présentant ainsi une grande surface et des épaisseurs faibles permettent de ce fait d'optimiser la surface d'échange avec l'air et de dissiper très rapidement les calories parvenant depuis la base 10 au dispositif dissipateur 100.

Par injection, en raison de dépouilles nécessaires et de la disposition des injecteurs, il serait beaucoup plus difficile d'obtenir une grande densité de parois fines. De préférence, les éléments dissipateurs 101 sont en aluminium.

La base 10 et les éléments dissipateurs 101 présentent ainsi deux fonctions complémentaires qui, en synergie, permettent un refroidissement très efficace des DEL 2.

La base 10 extrait les calories produites par les DEL 2, les emmagasine et peut les transférer rapidement aux éléments dissipateurs 101 via les portions de fixation 107. Les éléments dissipateurs 101 quant à eux dissipent dans l'air par convection les calories rapportées par la base 10.

Comme illustré en figure 2, les portions de fixation 107 des éléments dissipateurs 101 forment ensemble un socle 106 assurant la fixation à la base 10 et l'échange thermique par conduction avec la base 10. Ce socle 106 comporte de préférence des extrémités de fixation 108 disposées au contact de la base 10 et de part et d'autre de l'ensemble formé par les parois dissipatrices 102.

Sur cet exemple illustré en figures 1 et 2, le dispositif dissipateur 100 forme des canaux 103 parallèles les uns aux autres. Ces canaux 103 sont formés par une bande pliée en accordéon. Deux parois dissipatrices 102 adjacentes sont liées entre elles par un pli.

Ainsi, certains canaux 103' présentent un pli situé au niveau d'une extrémité proximale 105 disposée au droit de la base 10 et une ouverture située au niveau d'une extrémité distale 104. Cela permet de favoriser une bonne circulation de l'air au niveau de l'extrémité distale 104 de la paroi selon l'axe x. Un canal 103" adjacent au canal 103' présente quant à lui un pli au niveau de son extrémité distale 104 et une ouverture située au niveau d'une extrémité proximale 105. Cela permet de favoriser la circulation de l'air au niveau de la base 10. Cette configuration permet donc d'optimiser la dissipation par convection des calories emmagasinées par les parois 103.

On notera que, de manière particulièrement avantageuse, la présence des portions de fixation 107 permet d'assurer un bon transfert thermique entre la base 10 et le dispositif dissipateur 100 tout en favorisant la circulation de l'air au sein des canaux 103. En effet, ces canaux sont largement ouverts.

Par rapport à une configuration dans laquelle les canaux 103 seraient formés par des ailettes jointes deux à deux de manière à former un « U », les extrémités des branches du « U » reposant en partie sur la base 10 et s'étendant selon la dimension x, l'invention offre le même avantage que précédemment. Par ailleurs, elle offre pour avantage de ne pas fermer le canal 103 sur toute sa dimension selon l'axe x, mais que sur la portion de canal 103 au contact de la base 10, améliorant de ce fait la circulation de l'air selon l'axe z et la dissipation des calories.

Par rapport à une configuration dans laquelle les canaux 103 seraient formés par des ailettes jointes deux à deux de manière à former un « U », le fond du « U » s'étendant perpendiculairement à la base 10 et à partir de cette dernière, l'invention offre pour avantage d'augmenter la surface d'échange entre les éléments dissipateurs 101 et la base 10 sans nuire à la circulation de l'air.

De manière avantageuse, et comme illustré en figure 2, l'organe de refroidissement 1 comprend deux dispositifs dissipateurs 100a, 100b associés à une même base 10. Les portions de fixation 107 du dispositif dissipateur 100a sont fixées sur la face de fixation 11 alors que les portions de fixation 107 du dispositif dissipateur 100b sont fixées sur la face opposée à la face de fixation 11.

Cette configuration permet de dissiper encore plus efficacement les calories. De préférence, les parois dissipatrices 102a du dispositif dissipateur 100a sont situées au droit des parois dissipatrices 102b du dispositif dissipateur 100b. Deux parois dissipatrices 102a, 102b forment donc ensemble une même paroi dissipatrice 102a, d'un même canal. L'air peut donc plus aisément circuler selon l'axe z.

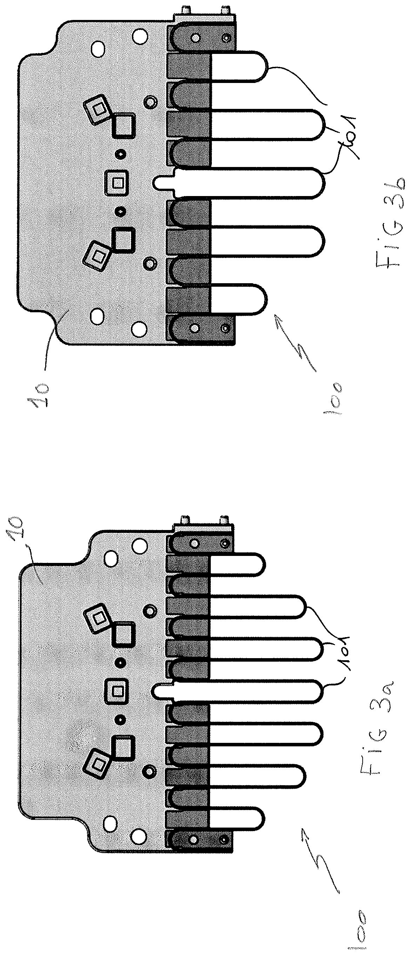

Les **figures 3a à 3c** illustrent plusieurs variantes de réalisation de l'invention qui peuvent toutes s'adapter à une même base 10.

Dans chacune de ces variantes, le dispositif dissipateur 100 est de préférence formé par une tôle continue et pliée de manière à définir les parois dissipatrices 102 parallèles entre elles et les portions de fixation 107 perpendiculaires aux parois dissipatrices 102. Il y a ainsi continuité de matière entre les éléments dissipateurs 101.

La figure 3a est une vue du dessus (selon l'axe z) de l'organe de refroidissement 1 illustré en figure 1.

Le dispositif dissipateur 100 comporte sept éléments dissipateurs 101 portant ensemble quatorze parois dissipatrices 102 et treize canaux 103. La distance entre deux parois dissipatrices 102 est consécutive et par exemple de 6mm. Deux parois dissipatrices 102 consécutives sont reliées entre elles par une portion arrondie. Les parois dissipatrices 102 situées en extrémité du dispositif dissipateur 100 selon l'axe x sont plus courtes que celles situées au centre. Cela permet d'augmenter la surface d'échange avec la partie centrale de la base 10, de manière à favoriser la dissipation des calories tout en réduisant l'encombrement et le poids là où une dissipation moins forte est requise.

La figure 3b est une vue de dessus de l'organe de refroidissement 1 de la figure 2. Par rapport à la variante de la figure 3a, celle de la figure 3b présente une densité plus faible des parois dissipatrices 102 et donc de canaux 103, ici au nombre de dix et neuf respectivement.

Le poids du dispositif dissipateur 100 est donc réduit par rapport à celui de la figure 3a mais la surface d'échange est plus faible. On privilégiera ce mode de réalisation pour des systèmes générant moins de chaleur que ceux associés à l'organe de refroidissement 1.

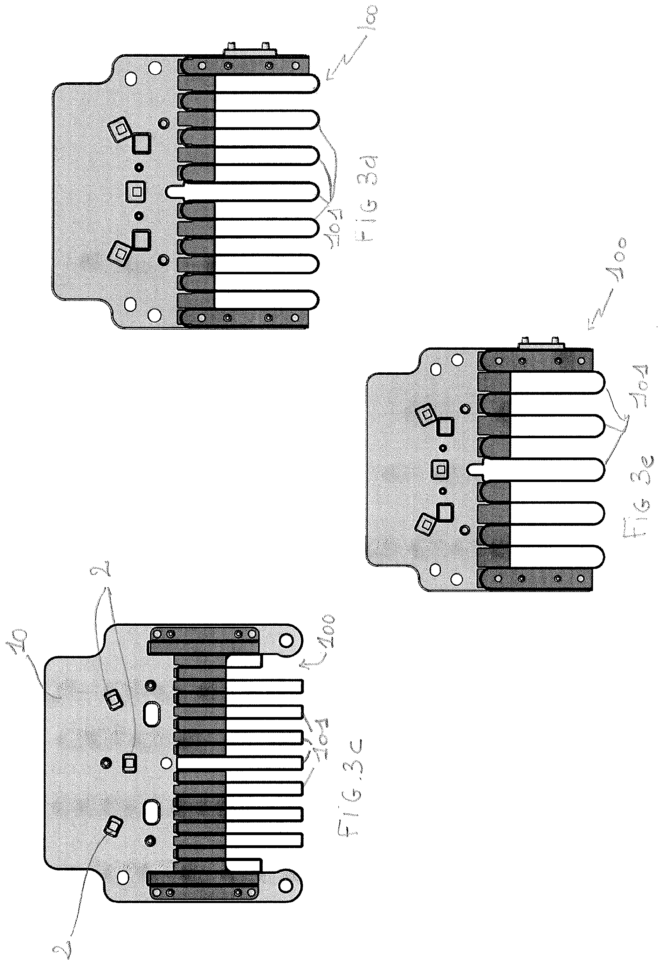

Les figures 3c à 3e présentent des éléments dissipateurs 101 qui ont tous la même longueur. La variante de la figure 3c présente des parois dissipatrices 102 reliées deux à deux par des plis en angle droit. Le fond des « U » forme ainsi un angle droit avec les branches du « U ». L'espace entre deux parois dissipatrices 102 mesure, dans cet exemple non limitatif, 4mm.

Les variantes des figures 3d et 3e présentent des plis arrondis entre deux parois dissipatrices 102 consécutives. Typiquement, ces organes de refroidissement pèsent entre 102g (variante de la figure 3b) et 130g (variante de la figure 3d). Les parois dissipatrices 102 étant formées en aluminium à partir d'une tôle pliée et la base 10 étant en alliage d'aluminium et de silicium formée par moulage par injection, formage ou découpage.

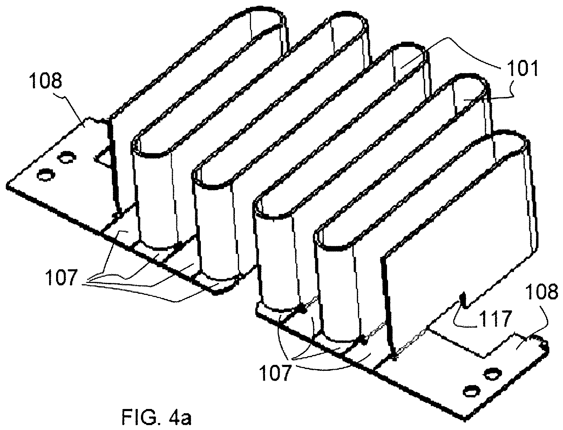

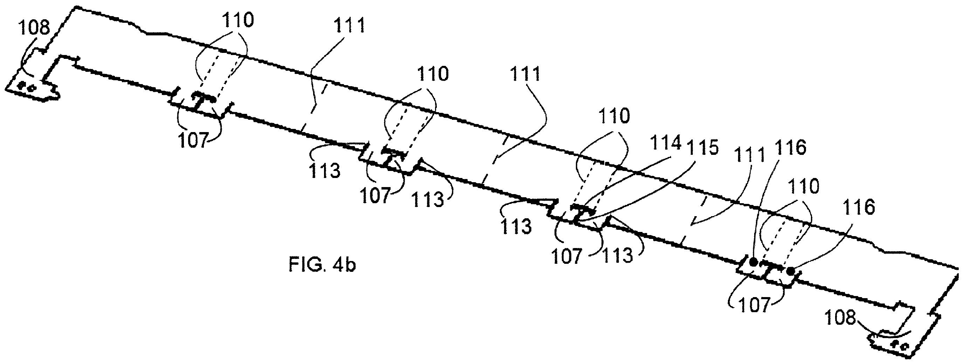

Les **figures 4b à 4h** illustrent certaines étapes de réalisation d'un dispositif dissipateur 100 illustré en **figure 4a** et qui est proche de celui illustré en figure 2.

L'étape 4b montre la tôle découpée, avant pliage, qui va servir à la formation de tout le dispositif dissipateur 100 de la figure 4a.

Cette tôle forme un élément plan, de forme sensiblement longitudinale, délimité par deux bords longitudinaux 119 s'étendant chacun selon l'axe Y. Cette tôle définit les deux extrémités de fixation 108, les portions de fixation 107 et des lignes de pliage 110, 111, 112.

Les lignes de pliage 110, 111 s'étendent transversalement d'un bord longitudinal 119 à l'autre. Les lignes de pliage 110, 111 sont destinées à former la jonction deux parois dissipatrices 102 consécutives (c'est-à-dire le fond d'un « U »).

En fonction du pliage et de la disposition des lignes de pliage 110, 111, le fond du « U » sera arrondi ou plat.

Les lignes 110 définissent les plis aux extrémités proximales 105 tandis que les plis 111 définissent les plis aux extrémités distales 104.

Les portions de fixation 107 sont définies par les découpes 113, 114, 115 et présentent chacune une jonction 116 avec la paroi dissipatrice 102 à laquelle elle est associée. Cette jonction 116 est destinée à être pliée pour permettre à la paroi dissipatrice 102 d'être contenue dans le plan zx et à la portion de fixation 107 d'être contenu dans le plan xy.

La figure 4c illustre une portion de tôle après pliage au niveau des plis 110 et 111. Cette portion de tôle présente deux parois dissipatrices 102 définissant un canal 103.

La portion de fixation 107 disposée sur la gauche a été pliée. Elle s'étend ainsi dans le plan xy. La portion de fixation 107 disposée à droite n'a pas encore été pliée et va l'être au niveau de la ligne de pliage 112 de la jonction 116 comme illustré en figure 4d.

Cette figure montre clairement le dégagement d'une arête 117 formée par la ligne de découpe 113 et qui apparaît suite au pliage. Cette arête 117 est destinée à buter contre l'épaisseur de la base 110 pour faciliter la mise en position et le maintien en position du dispositif dissipateur 100 sur la base 10.

La figure 4e illustre une vue partielle de la tôle pliée faisant apparaître la juxtaposition de cinq parois dissipatrices 102. Les portions de fixation 107a sont pliées et juxtaposées les unes aux autres. Elles forment ainsi un socle 106 continu ce qui optimise la surface 109 de contact entre le dispositif dissipateur 100 et la base 10. La portion 107b est quant à elle illustrée dans une position non pliée.

Selon la figure 4f, cette portion 107b est pliée en étant rabattue sous le fond du « U ». Ainsi, toutes les portions de fixation 107 sont rabattues selon le même sens de rotation.

On notera que cette structure permet également un contact entre la portion de fixation 107b et le fond du « U », ce qui améliore la propagation des calories depuis la portion de fixation 107b vers le fond du « U » et les parois dissipatrices 102 adjacentes au « U ».

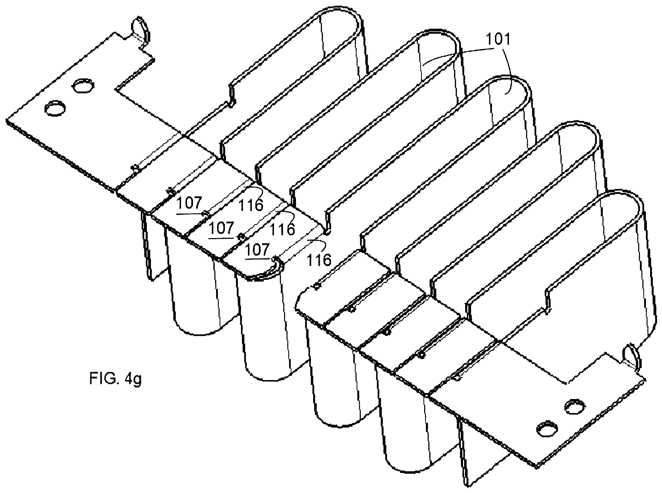

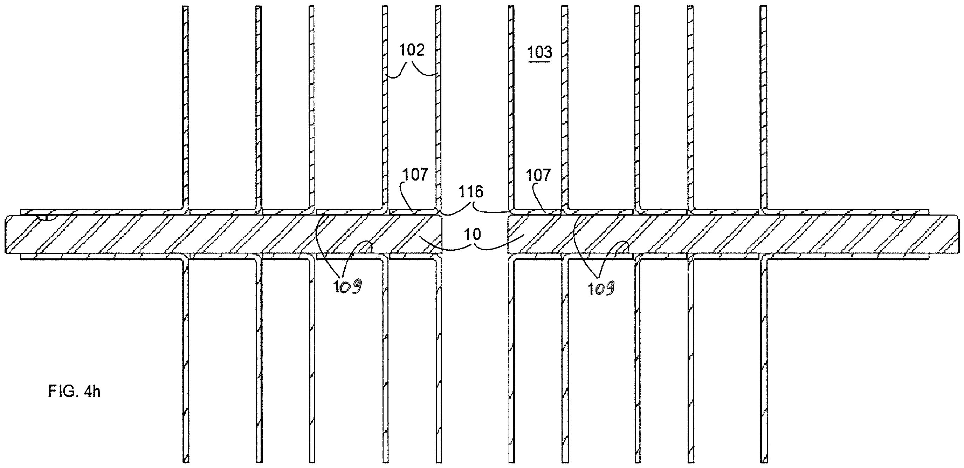

La figure 4g illustre le dispositif dissipateur 100 vu du dessous une fois entièrement plié. La figure 4h illustre le dispositif dissipateur 100 vu en coupe selon un plan xz.

Sur ces deux dernières figures, on remarque clairement que les portions de fixation 107 forment un socle 106 sans espace vide pour augmenter la surface 109 de contact avec la base 10.

Ainsi, de manière particulièrement avantageuse, deux portions de fixation adjacentes présentent une discontinuité de matière mais sont accolées ou sont distantes d'une distance D faible. D est typiquement inférieure à 1/10 de la distance séparant les deux parois dissipatrices 102 adjacentes au niveau de leurs extrémités proximales 105. Cette distance D est mesurée selon une direction perpendiculaire à la direction selon laquelle les portions 102 s'étendent, dans les exemples illustrés il s'agit de la direction Y.

Dans tous les modes de réalisation décrits ci-dessus, l'air peut circuler dans des canaux 103 librement, selon l'axe z et aussi selon l'axe x sauf soit à l'extrémité proximale 105, soit à l'extrémité distale 104 du canal 103.

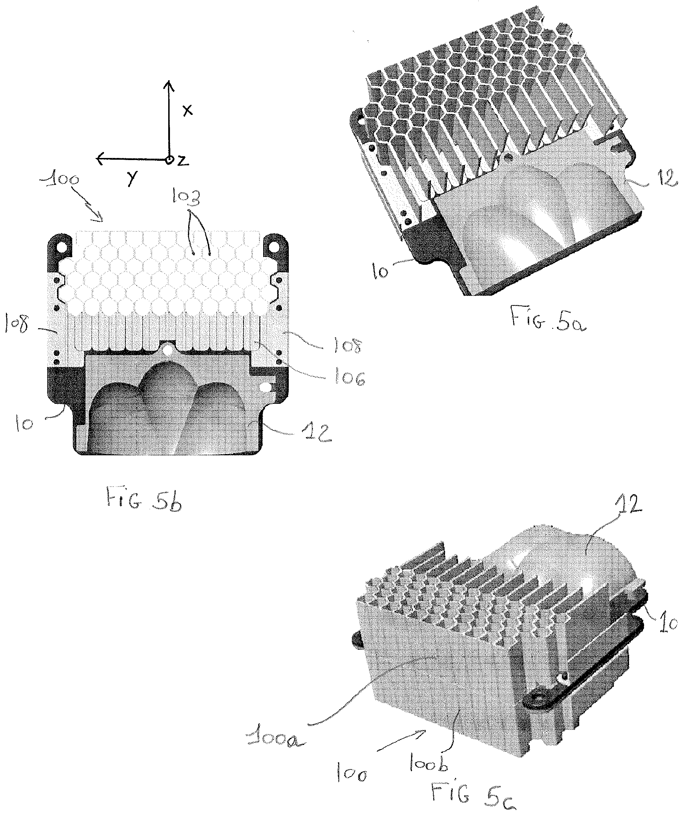

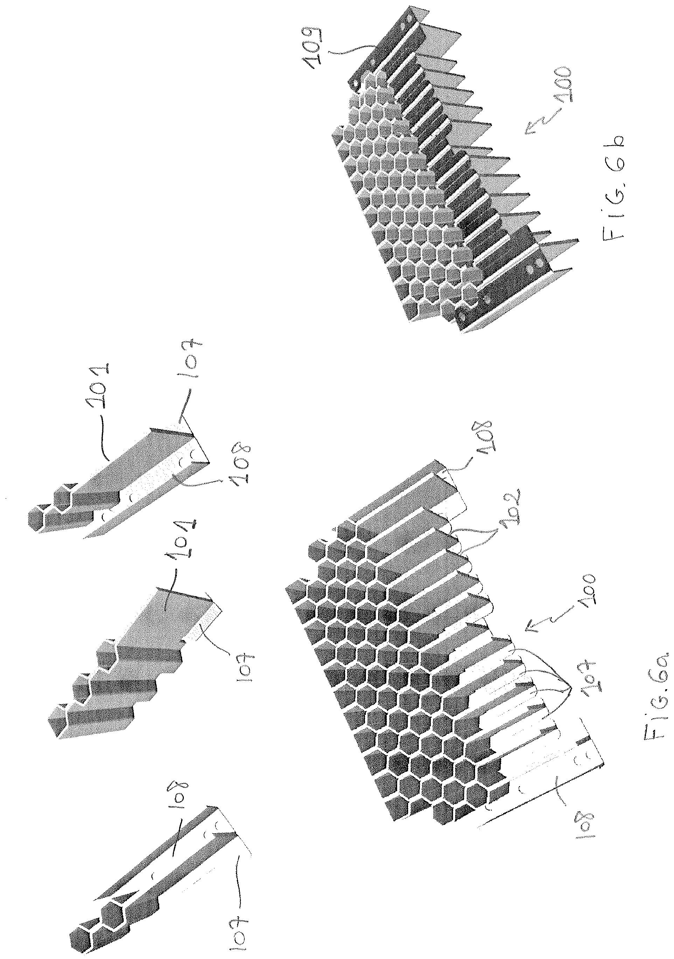

Les **figures 5a à 5c** et **6a et 6b** illustrent un autre mode de réalisation de l'invention dans lequel les éléments dissipateurs 101 forment des canaux présentant en section, un pourtour fermé. Sur cet exemple non limitatif, les canaux 103 s'étendent selon l'axe z. Ils présentent en coupe, selon le plan xy, un pourtour fermé, ici un pourtour alvéolaire

De préférence, chaque élément dissipateur 101 présente une portion proximale formant une paroi rectiligne s'étendant selon l'axe x et qui se prolonge par plusieurs canaux alvéolés 103.

De préférence, chaque élément dissipateur 101 est obtenu individuellement. Il n'est pas formé venu de matière avec l'élément dissipateur 101 qui lui est adjacent.

L'assemblage des éléments dissipateurs 101 forme le dispositif dissipateur 100. De préférence, la juxtaposition de deux éléments dissipateurs 101 forme entre ces éléments dissipateurs 101 des alvéoles. L'assemblage obtenu forme une structure alvéolaire continue.

De préférence un élément dissipateur 101 est obtenu par pliage sur elle-même d'une feuille de métal ou d'une tôle. Les deux extrémités de la tôle étant fixées l'une à l'autre après pliage, cette fixation étant assurée préférentiellement par clinchage, sertissage ou par soudure électrique.

Avantageusement, chaque portion rectiligne est formée par deux parois dissipatrices 102 repliées l'une sur l'autre. Chaque paroi dissipatrice 102 se prolonge par une portion de fixation 107 pliée dans le plan perpendiculaire à celui des parois dissipatrices 102. Les éléments dissipateurs 101 sont ainsi formés individuellement, mais possiblement simultanément. Ils sont ensuite assemblés et fixés les uns aux autres, de préférence par clinchage, sertissage ou par soudure électrique. L'assemblage ainsi constitué forme le dispositif dissipateur 100 illustré en figures 6a et 6b. Il constitue un sous-ensemble prêt à être rapporté sur la base 10.

On peut recourir à un procédé dit submount dans lequel on réalise la fixation d'un élément, par exemple la diode, directement sur un support, ici la base, via de la colle ou de la soudure pour optimiser la dissipation thermique. Ce procédé implique la disparition du substrat métallique sur lequel est montée la diode. On réalise donc généralement un pontage (wirebonding - câblage de connexion) vers un PCB distant de la diode, ici un PCB flexible qui relie ainsi la diode à un circuit de pilotage.

De préférence, les portions de fixation 107 s'étendent sur toute la dimension selon l'axe x de la portion rectiligne proximale. La juxtaposition continue de ces portions de fixation 107 forme le socle 106 de fixation, comme illustré en figure 6b, c'est ce socle 106 de fixation qui définit la surface de contact 109 entre le dispositif dissipateur 100 et la base 10.

Ainsi, et comme décrit pour le mode de réalisation précédent, deux portions de fixation adjacentes présentent une discontinuité de matière mais sont accolées ou sont distantes d'une distance D faible, typiquement inférieure à 1/10 de la distance séparant les deux parois dissipatrices 102 adjacentes au niveau de leurs extrémité proximales 105.

De préférence, comme illustré en figure 5c, on rapporte deux dispositifs dissipateurs 100a, 100b, sur chacune des faces de la base 10. Chaque canal alvéolaire 103 formé par l'un des dispositifs dissipateurs 100a, 100b se prolonge par un canal alvéolaire 103 de l'autre dispositif dissipateur 100a, 100b.

Pour faciliter la production et pour réduire les coûts, les dispositifs dissipateurs 100a, 100b sont identiques.

Dans ce mode de réalisation, on prévoit un réflecteur 12 disposé sur la face de la base 10 qui supporte la DEL 2.

Ce mode de réalisation offre ainsi une structure présentant une surface d'échange optimisée et permettant une libre circulation de l'air dans les canaux 103 selon l'axe z.

En fonction des contraintes de poids et de puissance thermique à dissiper, on fera varier la densité des alvéoles pour un même encombrement.

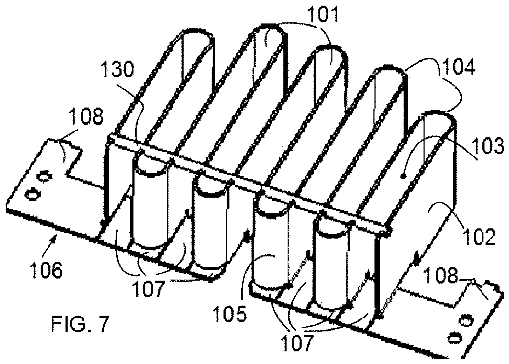

Les **figures 7 à 10b** illustrent plusieurs exemples de réalisation permettant de renforcer la robustesse du dispositif dissipateur 100. Ces modes de réalisation sont combinables entre eux et avec les modes de réalisation décrits en référence aux figures précédentes.

Ces modes de réalisation seront très avantageux s'ils sont appliqués à des éléments dissipateurs 101 obtenus individuellement et fixés les uns aux autres pour former un dispositif dissipateur 100. Néanmoins, ils s'appliquent également aux cas où l'ensemble des éléments dissipateurs 101 est formé d'un seul tenant, typiquement par pliage d'une unique feuille de métal.

Dans ce mode de réalisation de la **figure 7****,** on prévoit une barre 130 solidaire de certaines et de préférence solidaire de toutes les parois dissipatrices 102.

Avantageusement, un bord des parois dissipatrices 102 présente une encoche complémentaire de la forme de la barre 130 et configurée pour loger une partie au moins de la barre 130.

La barre 130, une fois insérée dans l'encoche, peut être fixée aux parois dissipatrices 102 par soudage ou brasage. Ainsi, la cohésion des parois dissipatrices 102 est renforcée.

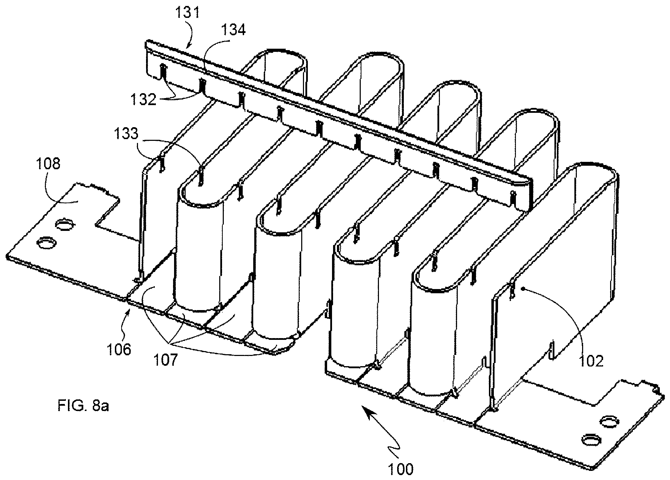

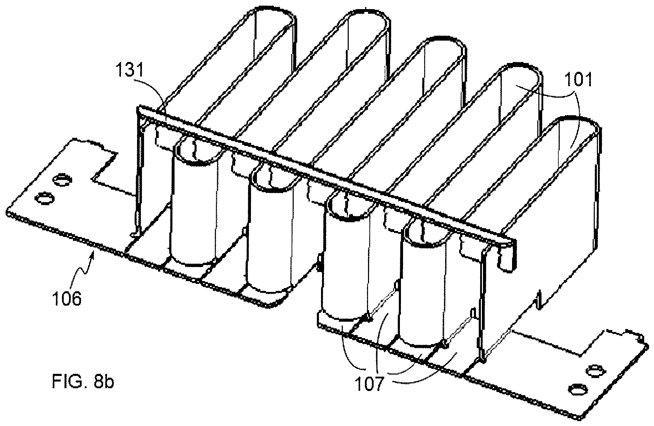

Les **figures 8a** **et** **8b** illustrent un mode de réalisation dans lequel la base 10 présente une forme de peigne 131 présentant des fentes 132 disposées longitudinalement selon l'axe y et configurées pour être pénétrées par les parois dissipatrices 102.

De préférence, les parois dissipatrices 102 présentent également des fentes 133 configurées pour recevoir le peigne 131 au niveau des fentes 132. L'emboîtement des fentes 132 dans les fentes 133 permet une bonne fixation du peigne 131 sur les parois dissipatrices 102, fixation renforcée au besoin par soudage ou brasage.

De préférence, le peigne 131 est obtenu par découpe d'une feuille métallique, notamment pour former les fentes 132 et par pliage d'une bordure pour former une nervure 134 renforçant la robustesse de l'ensemble.

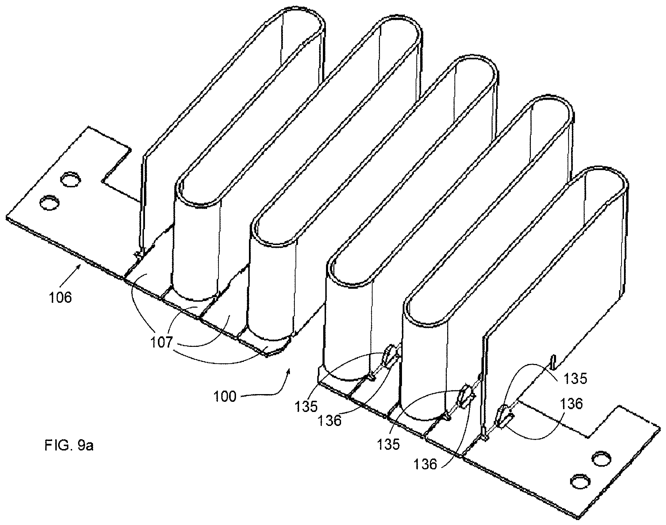

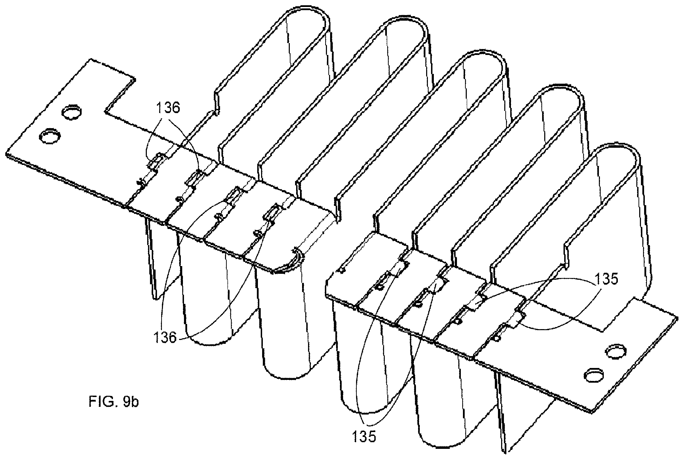

Les **figures 9a** **et** **9b** illustrent un mode de réalisation dans lequel des crochets 135 renforcent la fixation entre la portion de fixation 107 d'une première paroi dissipatrice 102 et une deuxième paroi dissipatrice 102 adjacente à cette première paroi dissipatrice 102.

Un crochet 135 porté par la portions de fixation 107 de la première paroi dissipatrice 102 est prévu pour pénétrer dans une ouverture 106 pratiquée dans la deuxième paroi dissipatrice 102 et à proximité de cette dernière. Le crochet 135 est configuré pour venir en prise avec la deuxième paroi dissipatrice 102.

Avantageusement, les crochets 135 font partie de la feuille de métal constituant les parois dissipatrices 102.

Pour assurer l'activation de la fixation par crochet après juxtaposition des parois dissipatrices 102 et des portions de fixation 107, on plie les crochets 135 en les rabattant de manière à les faire pénétrer dans l'ouverture 136 de la portion de fixation 107 adjacente.

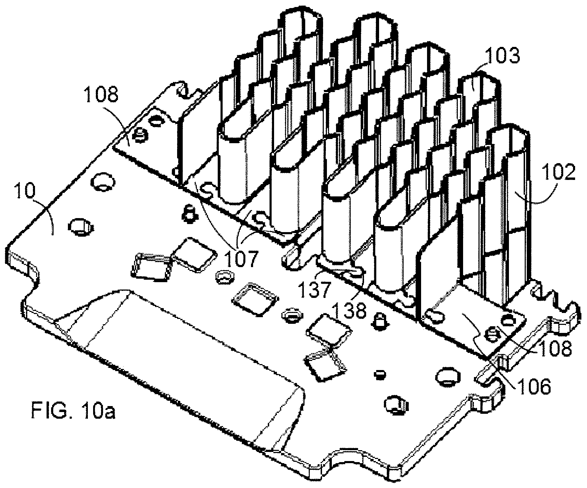

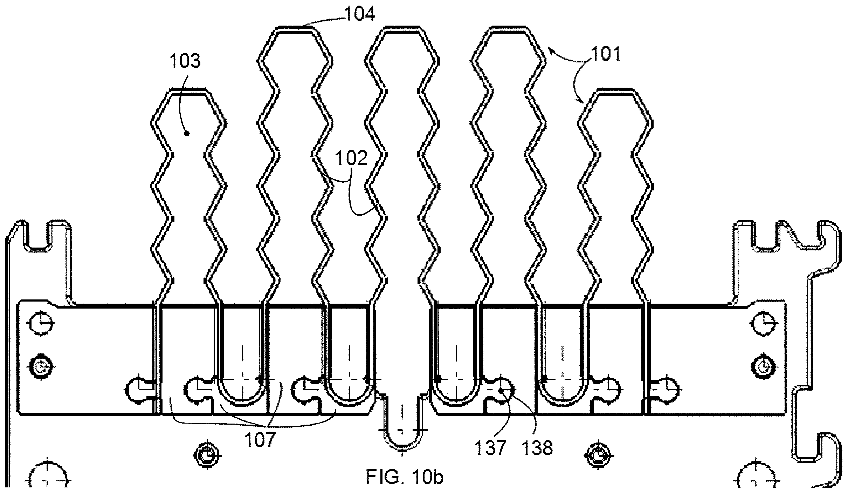

Les **figures 10a** **et** **10b** illustrent un mode de réalisation dans lequel deux portions de fixation 107 consécutives présentent une partie mâle 136 et une partie femelle 137 configurées pour coopérer ensemble de manière à assurer un blocage des deux portions de fixation 107.

Comme illustré sur ces figures, les portions de fixation 107 portant ces deux parties mâle 136 et femelle 137 forment deux pièces d'un puzzle. Cela permet de faciliter la mise en position et le maintien en position des éléments dissipateurs 101 entre eux. Ainsi une portion de fixation porte une partie mâle configurée pour coopérer par emboitement avec une partie femelle portée par une portion de fixation qui lui est adjacente. Le dispositif dissipateur est configuré de manière à ce que la coopération les parties mâles et femelle empêche le désemboitement des portions de fixation adjacentes lorsque les portions de fixation adjacentes sont déplacés relativement selon une direction parallèle (direction X ou Y) au plan des faces de la base. En revanche, un déplacement relatif des portions de fixation selon une direction perpendiculaire (direction Z) au plan des faces de la base permet un désemboitement des portions de fixation.

Egalement, les parois dissipatrices du dissipateur présentent une forme particulière basée sur le mode de réalisation illustré aux figures 4a à 4h, mais modifiée pour se rapprocher également des avantages des modes de réalisation alvéolaires précédemment décrits. A la différence des parois dissipatrices illustrées aux figures 4a à 4h, celles-ci sont ondulées au lieu d'être planes. On augmente ainsi la surface d'échange.

L'ondulation génère ainsi une alternance de creux et de sommets sur les faces des parois dissipatrices. Comme dans l'exemple illustré, les sommets des faces de deux parois adjacentes formant un canal d'air, ces faces étant en vis-à-vis, sont en vis-à-vis. De même, les creux de ces faces sont en vis-à-vis.

Cette ondulation peut par exemple être formée par une pluralité de plis successifs, par exemples les parois dissipatrices étant en accordéon. De la description qui précède, il ressort clairement que l'invention offre une solution particulièrement efficace pour dissiper les calories emmagasinées par la base 10. La disposition des parois dissipatrices 102, en particulier leur porte-à-faux par rapport à la base 10, leur formation possiblement par pliage, la libre circulation d'air qu'elles autorisent et le bon transfert thermique entre la base 10 et les parois dissipatrices 102, renforcent l'efficacité de la dissipation thermique.

L'invention n'est pas limitée aux modes de réalisations précédemment décrits et s'étend à tous les modes de réalisation couverts par les revendications.

Notamment, l'invention s'étend à des dispositifs dissipateurs 100 formés d'éléments dissipateurs 101 réalisés individuellement puis assemblés entre eux ou au contraire d'éléments dissipateurs 101 liés entre eux et formés à partir d'une même famille de métal.

Par ailleurs, l'invention n'est pas limitée à des parois et à des canaux présentant les formes illustrées sur les figures. Elle englobe toute forme de parois et canaux et s'étend notamment à des parois formant des ailettes.

### REFERENCES

- 1.: Organe de refroidissement
- 2.: Source lumineuse
- 3.: Circuit imprimé

- 10.: Base
- 11.: Face de fixation
- 12.: Réflecteur

- 100.: Dispositif dissipateur
- 101.: Élément dissipateur
- 102.: Paroi
- 103.: Canal
- 104.: Extrémité distale
- 105.: Extrémité proximale
- 106.: Socle
- 107.: Portion de fixation
- 108.: Extrémité de fixation du socle
- 109.: Surface d'échange dispositif dissipateur / base
- 110.: Ligne de pliage
- 111.: Ligne de pliage
- 112.: Ligne de pliage
- 113.: Découpe
- 114.: Découpe
- 115.: Découpe
- 116.: Jonction
- 117.: Arête
- 118.: Face de contact entre élément dissipateur et base
- 119.: Bord longitudinal

- 130.: Barre
- 131.: Peigne
- 132.: Fente
- 133.: Fente complémentaire
- 134.: Nervure
- 135.: Crochet
- 136.: Ouverture complémentaire
- 137.: Partie mâle
- 138.: Partie femelle

## Revendications

1. Système d'éclairage et/ou de signalisation pour véhicule automobile comprenant :
- un organe de refroidissement (1) comprenant une base (10) (10) présentant deux faces opposées dont l'une au moins est configurée pour supporter une source lumineuse (2) dudit système et au moins un dispositif dissipateur (100) de chaleur en liaison de conduction thermique à ladite base (10), le dispositif dissipateur (100) comprenant une pluralité d'éléments dissipateurs (101), chaque élément dissipateur (101) de ladite pluralité comprenant au moins une paroi dissipatrice (102) s'étendant depuis une face de fixation (11) prise parmi l'une desdites faces de ladite base (10) et dans un plan incliné par rapport au plan de la face de fixation (11), la paroi dissipatrice ou au moins certaines des parois dissipatrices (102) d'un élément dissipateur (101) se prolongeant par une portion de fixation (107) par laquelle l'élément dissipateur (101) est rapporté et fixé sur ladite face de fixation (11), la portion de fixation (107) étant formée venu de matière avec la paroi dissipatrice (102) correspondante et s'étendant principalement dans le plan de ladite face de fixation (11), la portion de fixation et la paroi dissipatrice correspondante étant formées par une tôle pliée, un pli de cette tôle séparant la portion de fixation et la paroi dissipatrice correspondante, le système étant **caractérisé en ce qu'**il comprend
- une source lumineuse (2) supportée par ladite face de fixation (11), et
- un dispositif optique configuré pour modifier la direction du rayonnement lumineux émis par la source.

2. Système selon la revendication précédente dans lequel la portion de fixation (107) et la paroi dissipatrice (102) sont à un angle de 90° au niveau du pli.

3. Système selon l'une des revendications 1 à 2 dans lequel la portion de fixation (107) d'une première paroi dissipatrice (102) est rapportée au contact de l'un parmi : une deuxième paroi dissipatrice (102) adjacente à la première paroi dissipatrice (102) ou une portion de fixation (107) de la deuxième paroi dissipatrice.

4. Système selon l'une des revendications 1 à 2 dans lequel la portion de fixation (107) d'une première paroi dissipatrice (102) est rapportée à une distance inférieure à la distance D de l'un parmi : la deuxième paroi dissipatrice (102) adjacente à la première paroi dissipatrice (102) ou la portion de fixation (107) de la deuxième paroi dissipatrice, la distance D étant inférieure ou égale à la moitié de la distance séparant les première et deuxième parois dissipatrices (102) au niveau des portions de fixation (107).

5. Système selon l'une quelconque des revendications précédentes dans lequel la portion de fixation (107) s'étend perpendiculairement à ladite paroi dissipatrice (102) qu'elle prolonge de manière à former une ailette.

6. Système selon l'une quelconque des revendications précédentes dans lequel l'élément dissipateur (101) forme un canal (103) de circulation d'air délimité par deux parois dissipatrices (102), le canal (103) étant ouvert à deux de ses extrémités selon une direction perpendiculaire à la face de fixation (11) et le canal (103) est ouvert selon une direction d'extension principale selon laquelle s'étend la paroi dissipatrice (102).

7. Système selon l'une quelconque des revendications précédentes dans lequel les éléments dissipateurs (101) sont ensemble formés venu de matière, deux parois dissipatrices (102) adjacentes présentant une continuité de matière.

8. Système selon l'une quelconque des revendications 1 à 6 dans lequel chaque élément dissipateur (101) est constitué par une tôle pliée distincte, les éléments dissipateurs (101) étant distincts de la base (10) et fixés sur cette dernière, notamment par de la colle ou par une soudure.

9. Système selon l'une quelconque des revendications précédentes dans lequel le dispositif dissipateur (100) comprend au moins un élément de liaison rapporté sur au moins une pluralité et de préférence toutes les parois dissipatrices (102) et liant entre elles les parois dissipatrices (102) de ladite pluralité.

10. Système selon l'une quelconque des revendications précédentes dans lequel le dispositif dissipateur (100) comprend au moins un crochet (135) solidaire d'une portion de fixation (107) et configuré pour coopérer avec une ouverture (136) pratiquée dans une portion de fixation (107) adjacente.

11. Système selon l'une quelconque des revendications précédentes dans lequel une portion de fixation (107) porte une partie mâle (137) configurée pour coopérer par emboitement avec une partie femelle (138) portée par une portion de fixation (107) adjacente, la coopération les parties mâles (137) et femelle (138) empêchant le désemboitement des portions de fixation adjacentes selon certains mouvements relatifs des portions de fixation (107) adjacentes.

## Patentansprüche

1. Beleuchtungs- und/oder Signalsystem für ein Kraftfahrzeug, das enthält:
- ein Kühlorgan (1), das eine Bodenplatte (10) (10), die zwei gegenüberliegende Seiten aufweist, von denen mindestens eine konfiguriert ist, eine Lichtquelle (2) des Systems zu tragen, und mindestens eine Wärmeableitvorrichtung (100) in Wärmeleitverbindung mit der Bodenplatte (10) enthält, wobei die Ableitvorrichtung (100) eine Vielzahl von Ableitelementen (101) enthält, wobei jedes Ableitelement (101) der Vielzahl mindestens eine Ableitwand (102) enthält, die sich von einer von einer der Seiten der Bodenplatte (10) genommenen Befestigungsseite (11) und in einer geneigten Ebene bezüglich der Ebene der Befestigungsseite (11) erstreckt, wobei die Ableitwand oder mindestens bestimmte der Ableitwände (102) eines Ableitelements (101) sich durch einen Befestigungsabschnitt (107) verlängert, durch den das Ableitelement (101) an der Befestigungsseite (11) angebaut und befestigt wird, wobei der Befestigungsabschnitt (107) aus einem Stück mit der entsprechenden Ableitwand (102) geformt wird und sich hauptsächlich in der Ebene der Befestigungsseite (11) erstreckt, wobei der Befestigungsabschnitt und die entsprechende Ableitwand von einem Falzblech geformt werden, wobei ein Falz dieses Blechs den Befestigungsabschnitt und die entsprechende Ableitwand trennt,
wobei das System **dadurch gekennzeichnet ist, dass** es enthält
- eine von der Befestigungsseite (11) getragene Lichtquelle (2), und
- eine optische Vorrichtung, die konfiguriert ist, die Richtung der von der Quelle emittierten Lichtstrahlung zu ändern.

2. System nach dem vorhergehenden Anspruch, wobei der Befestigungsabschnitt (107) und die Ableitwand (102) im Bereich des Falzes in einem Winkel von 90° sind.

3. System nach einem der Ansprüche 1 bis 2, wobei der Befestigungsabschnitt (107) einer ersten Ableitwand (102) in Kontakt mit einem von: einer der ersten Ableitwand (102) benachbarten zweiten Ableitwand (102) oder einem Befestigungsabschnitt (107) der zweiten Ableitwand angebaut wird.

4. System nach einem der Ansprüche 1 bis 2, wobei der Befestigungsabschnitt (107) einer ersten Ableitwand (102) in einem Abstand geringer als der Abstand D von: der der ersten Ableitwand (102) benachbarten zweiten Ableitwand (102) oder dem Befestigungsabschnitt (107) der zweiten Ableitwand angebaut ist, wobei der Abstand D geringer als die oder gleich der Hälfte des Abstands ist, der die ersten und zweiten Ableitwände (102) im Bereich der Befestigungsabschnitte (107) trennt.

5. System nach einem der vorhergehenden Ansprüche, wobei der Befestigungsabschnitt (107) sich lotrecht zur Ableitwand (102) erstreckt, die er verlängert, um eine Rippe zu bilden.

6. System nach einem der vorhergehenden Ansprüche, wobei das Ableitelement (101) einen Luftzirkulationskanal (103) bildet, der von zwei Ableitwänden (102) begrenzt wird, wobei der Kanal (103) an zwei seiner Enden gemäß einer Richtung lotrecht zur Befestigungsseite (11) offen ist, und der Kanal (103) gemäß einer Hauptausdehnungsrichtung offen ist, gemäß der sich die Ableitwand (102) erstreckt.

7. System nach einem der vorhergehenden Ansprüche, wobei die Ableitelemente (101) zusammen aus einem Stück geformt sind, wobei zwei benachbarte Ableitwände (102) eine Materialkontinuität aufweisen.

8. System nach einem der Ansprüche 1 bis 6, wobei jedes Ableitelement (101) aus einem unterschiedlichen Falzblech besteht, wobei die Ableitelemente (101) sich von der Bodenplatte (10) unterscheiden und an dieser befestigt sind, insbesondere durch Klebstoff oder durch eine Schweißnaht.

9. System nach einem der vorhergehenden Ansprüche, wobei die Ableitvorrichtung (100) mindestens ein Verbindungselement enthält, das auf mindestens eine Vielzahl der und vorzugsweise alle Ableitwände (102) angebaut ist und die Ableitwände (102) der Vielzahl miteinander verbindet.

10. System nach einem der vorhergehenden Ansprüche, wobei die Ableitvorrichtung (100) mindestens einen Haken (135) enthält, der fest mit einem Befestigungsabschnitt (107) verbunden und konfiguriert ist, mit einer Öffnung (136) zusammenzuwirken, die in einen benachbarten Befestigungsabschnitt (107) eingearbeitet ist.

11. System nach einem der vorhergehenden Ansprüche, wobei ein Befestigungsabschnitt (107) einen Einsteckteil (137) trägt, der konfiguriert ist, durch Zusammenstecken mit einem Aufnahmeteil (138) zusammenzuwirken, der von einem benachbarten Befestigungsabschnitt (107) getragen wird, wobei die Zusammenwirkung der Einsteck- (137) und Aufnahmeteile (138) das Lösen der benachbarten Befestigungsabschnitte voneinander gemäß bestimmten relativen Bewegungen der benachbarten Befestigungsabschnitte (107) verhindert.

## Claims

1. Lighting and/or signalling system for a motor vehicle, comprising:
- a cooling member (1) comprising a base (10) (10) having two opposite faces, at least one of which is configured to support a light source (2) of said system and at least one heat dissipating device (100) connected for thermal conduction to said base (10), the dissipating device (100) comprising a plurality of dissipating elements (101), each dissipating element (101) of said plurality comprising at least one dissipating wall (102) extending from a fixing face (11) taken from one of said faces of said base (10) and in a plane inclined with respect to the plane of the fixing face (11), the dissipating wall or at least some of the dissipating walls (102) of a dissipating element (101) being continued by a fixing portion (107) by which the dissipating element (101) is attached and fixed to said fixing face (11), the fixing portion (107) being formed integrally with the corresponding dissipating wall (102) and extending mainly in the plane of said fixing face (11), the fixing portion and the corresponding dissipating wall being formed by a folded metal sheet, a fold of this metal sheet separating the fixing portion and the corresponding dissipating wall, the system being **characterized in that** it comprises
- a light source (2) supported by said fixing face (11), and
- an optical device configured to modify the direction of light radiation emitted by the source.

2. System according to the preceding claim, wherein the fixing portion (107) and the dissipating wall (102) are at an angle of 90° at the fold.

3. System according to either of Claims 1 and 2, wherein the fixing portion (107) of a first dissipating wall (102) is connected in contact with one of: a second dissipating wall (102) adjacent to the first dissipating wall (102) or a fixing portion (107) of the second dissipating wall.

4. System according to either of Claims 1 and 2, wherein the fixing portion (107) of a first dissipating wall (102) is attached at a distance less than the distance D from one of: the second dissipating wall (102) adjacent to the first dissipating wall (102) or the fixing portion (107) of the second dissipating wall, the distance D being less than or equal to half the distance between the first and second dissipating walls (102) at the fixing portions (107).

5. System according to any one of the preceding claims, wherein the fixing portion (107) extends perpendicularly to said dissipating wall (102) that it continues so as to form a fin.

6. System according to any one of the preceding claims, wherein the dissipating element (101) forms an air circulation channel (103) delimited by two dissipating walls (102), the channel (103) being open at two of its ends in a direction perpendicular to the fixing face (11) and the channel (103) being open in a main extension direction along which the dissipating wall (102) extends.

7. System according to any one of the preceding claims, wherein the dissipating elements (101) are all formed integrally, two adjacent dissipating walls (102) exhibiting a continuity of material.

8. System according to any one of Claims 1 to 6, wherein each dissipating element (101) is made up of a separate folded metal sheet, the dissipating elements (101) being separate from the base (10) and fixed to the latter, in particular by glue or by a weld.

9. System according to any one of the preceding claims, wherein the dissipating device (100) comprises at least one connecting element attached to at least a plurality of and preferably all of the dissipating walls (102) and linking the dissipating walls (102) of said plurality together.

10. System according to any one of the preceding claims, wherein the dissipating device (100) comprises at least one hook (135) secured to a fixing portion (107) and configured to cooperate with an opening (136) made in an adjacent fixing portion (107).

11. System according to any one of the preceding claims, wherein a fixing portion (107) carries a male part (137) configured to cooperate by interlocking with a female part (138) carried by an adjacent fixing portion (107), the cooperation of the male part (137) and female part (138) preventing the disconnection of the adjacent fixing portions by certain relative movements of the adjacent fixing portions (107).
